# EUROPEAN PATENT APPLICATION

(11) **EP 4 372 850 A1**
(43) Date of publication of application: **22.05.2024**
(21) Application number: 22215047.6
(22) Date of filing: 20.12.2022
(51) Int. Cl.: H01M 4/86, H01M 4/88

(54) **METHOD AND APPARATUS FOR ANALYZING FUEL CELL**

(30) Priority: 21.11.2022 KR 20220156567
(71) Applicant: Hyundai Mobis Co., Ltd., Gangnam-gu Seoul 06141 (KR)
(72) Inventor: LEE, Hyo June, 16891 Yongin-si (KR); LEE, Jin Hwa, 16891 Yongin-si (KR); LEE, Sung Chul, 16891 Yongin-si (KR); SHIN, Ju Ho, 16891 Yongin-si (KR); LEE, Kyung Jin, 16891 Yongin-si (KR); CHOI, Seung Kyu, 16891 Yongin-si (KR)
(74) Representative: Frenkel, Matthias Alexander

(57) **Abstract**

Disclosed is a method of fuel cell analysis. The method includes measuring at least a portion of an electrode of a fuel cell to determine a measured result. The method also includes analyzing a state of the fuel cell according to the measured result.

## Description

### CROSS-REFERENCE TO RELATED APPLICATION

This application claims the benefit under 35 use 9 119(a) of Korean Patent Application No. 10-2022-0156567, filed November 21, 2022, in the Korean Intellectual Property Office, the entire disclosure of which is incorporated herein by reference for all purposes.

### BACKGROUND

### 1. Field

The present invention relates to a method and apparatus for analyzing a fuel cell, and more particularly, to a degradation verification method and an air electrode pore size measurement method of a fuel cell membrane electrode assembly (MEA).

### 2. Description of Related Art

A membrane electrode assembly (MEA) of a fuel cell is divided into an air electrode/polymer electrolyte membrane/hydrogen electrode configuration. Hydrogen and air, which are used as fuel, flow into the air electrode and the hydrogen electrode through a separator/gas diffusion layer (GDL), respectively. At each electrode, hydrogen is oxidized to generate electrons, and hydrogen ions pass through the polymer electrolyte membrane and react with oxygen to produce electricity and water at the air electrode.

General components of the air electrode include a catalyst supported on carbon and a binder for maintaining ionic conduction and adhesion of components. Since an oxygen reduction reaction of the air electrode is slower than an oxidation reaction of the hydrogen electrode and water is continuously produced as a reactant, it is important that air used as fuel is uniformly supplied to the inside of an electrode having a microstructure during operation.

In addition, since an electrochemical reaction in which oxygen is reduced mainly occurs at a three-phase interface where three different phases of carbon/catalyst/binder are in contact with each other, it is also important to design an electrode layer using an appropriate dispersion method for a slurry compound. Therefore, the catalyst and the binder should be manufactured as an electrode after being prepared as a stably dispersed mixture using an appropriate solvent and environmental conditions.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, here is provided a method of fuel cell analysis. The method includes measuring a portion of an electrode of a fuel cell to determine a measured result. The method also includes analyzing a state of the fuel cell according to the measured result.

Measuring the portion of the electrode of the fuel cell may include measuring a pore size of the electrode of the fuel cell.

The method may include forming a portion of the electrode of the fuel cell by at least some of a coating process, a bonding process, and an attaching process.

Analyzing the state of the fuel cell may include analyzing the state of the fuel cell based on a measured pore size.

Measuring the portion of the electrode of the fuel cell may further include removing at least one of impurities and moisture located at least one of inside and around the electrode of the fuel cell.

Measuring the pore size of the electrode of the fuel cell may further include calculating the pore size based on a result of nitrogen supply to the electrode of the fuel cell.

In another general aspect, here is provided for fuel cell analysis. The apparatus includes an electrode measurer configured to measure at least a portion of an electrode of a fuel cell to determine a measured result, and a fuel cell state analyzer configured to analyze a state of the fuel cell according to the measured result.

The electrode measurer may be further configured to measure a pore size of the electrode of the fuel cell.

The electrode measurer may be further configured to measure at least a portion of an air electrode of the fuel cell.

The portion of the electrode of the fuel cell may be formed by at least some of a coating process, a bonding process, and an attaching process.

The fuel cell state analyzer may analyze the state of the fuel cell based on the measured pore size.

The apparatus for analyzing a fuel cell may further include an impurity remover configured to remove at least one of impurities and moisture located at least one of inside and around the electrode of the fuel cell.

The electrode measurer may be further configured to calculate the pore size based on a result of nitrogen supply to the electrode of the fuel cell.

Other features and aspects will be apparent from the following detailed description, the drawings, and the claims.

### BRIEF DESCRIPTION OF THE DRAWINGS

FIG. 1 is a flowchart illustrating a method of analyzing a fuel cell according to an embodiment.
FIG. 2 is a diagram illustrating an analysis target of the method of analyzing a fuel cell according to an embodiment.
FIG. 3 is a diagram illustrating processes in the method of analyzing a fuel cell according to an embodiment.
FIG. 4 is a graph showing a relationship between a measured pore size of an electrode and a degradation increase rate in the method of analyzing a fuel cell according to an embodiment.
FIG. 5 is a block diagram illustrating an apparatus for analyzing a fuel cell according to an embodiment.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Advantages and features of the present disclosure and methods of achieving the advantages and features will be clear with reference to embodiments described in detail below together with the accompanying drawings. However, the present disclosure is not limited to the embodiments disclosed herein but will be implemented in various forms. The embodiments of the present disclosure are provided so that the present disclosure is adequately disclosed, and a person with ordinary skill in the art can fully understand the scope of the present disclosure. Meanwhile, the terms used in the present specification are for explaining the embodiments, not for limiting the present disclosure.

Terms, such as first, second, A, B, (a), (b) or the like, may be used herein to describe components. Each of these terminologies is not used to define an essence, order or sequence of a corresponding component but used merely to distinguish the corresponding component from other component(s). For example, a first component may be referred to as a second component, and similarly the second component may also be referred to as the first component.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween.

The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Hereinafter, embodiments of the present invention will be described in detail with reference to the accompanying drawings, the same reference numerals are given to the same or corresponding components regardless of the drawing number, and duplicate descriptions thereof will be omitted herein.

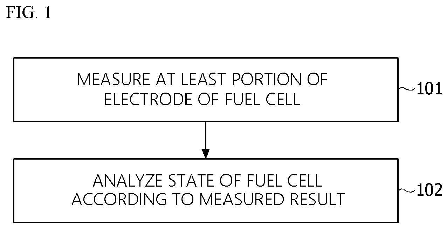

FIG. 1 is a flowchart illustrating a method of analyzing a fuel cell according to an embodiment.

According to an embodiment, each operation of the method of analyzing a fuel cell may be performed by at least some of components of an apparatus for analyzing a fuel cell, which will be described below.

The apparatus for analyzing a fuel cell may include at least some of a fuel cell system, a fuel cell analysis device, a fuel cell analyzer, fuel cell analysis instrument, a computing device, an electronic circuit, an electric circuit, and a semiconductor.

According to an embodiment, the apparatus for analyzing a fuel cell may remove moisture or impurities inside or around an electrode of a fuel cell.

According to an embodiment, at least a portion of an electrode of the fuel cell may be formed by at least some of a coating process, a bonding process, and an attaching process.

In operation 101, the apparatus for analyzing a fuel cell may measure at least a portion of an electrode of the fuel cell.

According to an embodiment, the apparatus for analyzing a fuel cell may measure a pore size of an electrode of the fuel cell.

According to an embodiment, the apparatus for analyzing a fuel cell may measure at least a portion of an air electrode of the fuel cell. The apparatus may thereby determine a measured result.

According to an embodiment, the apparatus for analyzing a fuel cell may compute/calculate the pore size on the basis of a result of nitrogen supply to an electrode of the fuel cell.

In operation 102, the apparatus for analyzing a fuel cell may analyze a state of the fuel cell according to the measured result.

According to an embodiment, the apparatus for analyzing a fuel cell may analyze the state of the fuel cell on the basis of the measured pore size.

The apparatus for analyzing a fuel cell may be connected to or include a display/output device. The apparatus for analyzing a fuel cell may display or transmit at least a portion of the measured result or the analyzed result to the display. In addition, the apparatus for analyzing a fuel cell may generate a graph or the like using at least a portion of the measured result or the analyzed result or display/transmit/output the graph to the display/output device.

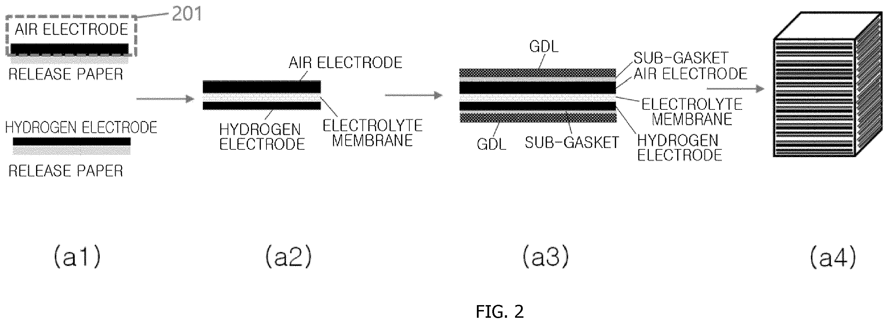

FIG. 2 is a diagram illustrating an analysis target of the method of analyzing a fuel cell according to an embodiment.

The fuel cell may include or use at least some of components shown in FIG. 2. At least some of the components shown in FIG. 2 may be disposed close to each other. The fuel cell may include a gas diffusion layer (GDL), a sub gasket, an air electrode, an electrolyte membrane, and a hydrogen electrode as components. A first component among the components of the fuel cell may be disposed on a second component different from the first component.

Referring to a1 of FIG. 2, an electrode coating of the fuel cell can be seen.

Referring to a2 of FIG. 2, the bonding between the electrodes and the electrolyte membrane of the fuel cell can be seen.

Referring to a3 of FIG. 2, the sub-gasket/GDL attachment of the fuel cell can be seen.

Referring to a4 of FIG. 2, a stack/stacking of the fuel cell can be seen.

A membrane electrode assembly (MEA), which is an electrode of the fuel cell, may undergo a process of coating air/hydrogen electrodes with release papers and bonding the air/hydrogen electrodes to the electrolyte membrane, and then a process of attaching a sub-gasket/GDL for facilitating sealing and fuel supply may be performed. Then, when a separator is positioned between each MEA and then stacking is performed, a fuel cell stack is formed. Durability evaluation of the fuel cell MEA the may be performed after the fuel cell stack is formed.

The apparatus for analyzing a fuel cell may provide a method of analyzing the pore size of the coated air electrode 201 and predicting degradation of the MEA.

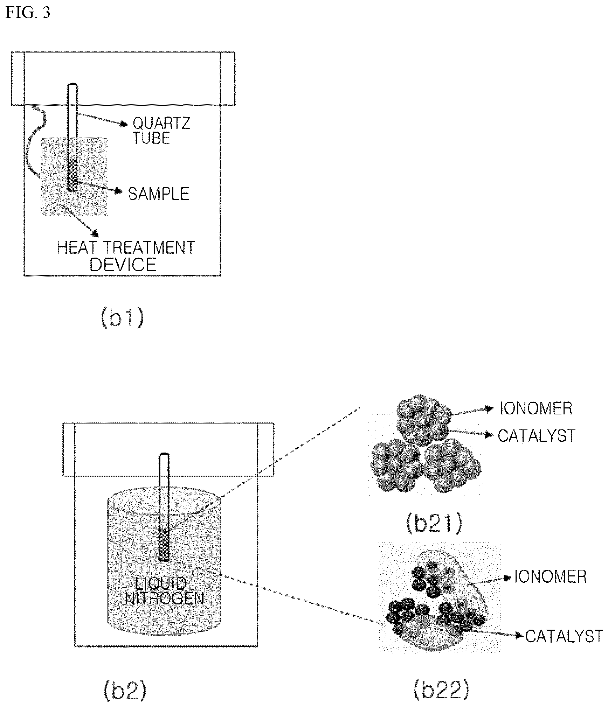

FIG. 3 is a diagram illustrating processes in the method of analyzing a fuel cell according to an embodiment.

The apparatus for analyzing a fuel cell may perform two processes that are a pretreatment process and an analysis process in an adsorption/desorption analysis method of used nitrogen. The apparatus for analyzing a fuel cell may perform at least some of the pretreatment process and the analysis process.

A specimen or sample may include at least a portion of the fuel cell.

Referring to b1 of FIG. 3, a pretreatment process of the apparatus for analyzing a fuel cell can be seen.

The pretreatment process is an operation of removing moisture and impurities in the sample and may be performed at a temperature ranging around 80 to 110 °C for 12 to 24 hours.

Referring to b2 of FIG. 3, an analysis process of the apparatus for analyzing a fuel cell can be seen.

The analysis process is an operation of analyzing a surface area of the sample. In the analysis process, a pretreated sample is put into a vessel containing liquid nitrogen, nitrogen gas is injected, and then the surface area may be measured by varying an amount of the nitrogen gas adsorbed on a sample surface while varying a relative pressure.

The apparatus for analyzing a fuel cell may analyze an electrode of the fuel cell (an electrode for the fuel cell). The apparatus for analyzing a fuel cell may analyze/use a dispersion state/dispersity of a catalyst or ionomer with respect to an electrode of the fuel cell.

An electrode may be coated with the catalyst and ionomer after the catalyst and ionomer are dispersed. In this case, a specific surface area of the catalyst, which is exposed, varies according to the dispersion state of the ionomer. In the case of being dispersed well, as the sample shown in b21 of FIG. 3, the ionomer uniformly surrounds the catalyst, otherwise, as shown in b22 of FIG. 3, the ionomer aggregates and thus the specific surface area of the exposed catalyst is changed.

A position where hydrogen/oxygen reacts in the fuel cell is a portion in which the catalyst and ionomer are dispersed well. However, as shown in b22 of FIG. 3, when the dispersity of the ionomer is low and thus an aggregated portion of the ionomer occurs, an active area is decreased, and when continuous reactions occur in the aggregated portion of the ionomer, hydrogen/oxygen transfer is hindered by generated water so that the generated water may be a cause of long-term degradation.

The apparatus for analyzing a fuel cell may analyze/calculate the degree of difference in the degree of degradation of the fuel cell according to the dispersity of the ionomer, convert/transform/compute/calculate a specific surface area measured after measuring the specific surface area of the exposed electrode into an average pore size, and provide a new index capable of determining/analyzing the degree of degradation of the fuel cell.

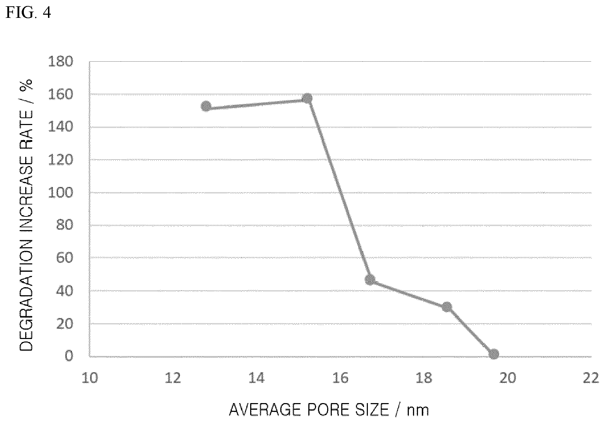

FIG. 4 is a graph showing a relationship between a measured pore size of an electrode and a degradation increase rate in the method of analyzing a fuel cell according to an embodiment.

Referring to FIG. 4, with reference to a relationship between the degradation increase rate and the pore size of an electrode measured by the nitrogen adsorption method, it can be seen that the degradation increase rate decreases as the average pore size increases.

The apparatus for analyzing a fuel cell may numerically determine/analyze that the degradation increase rate is reduced to 40% or less when the average pore size is 16 nm or more.

The apparatus for analyzing a fuel cell may predict/determine/derive that durability is improved when the average pore size of the fuel cell is formed to be 16 to 17 nm or more during manufacturing of an electrode layer of the fuel cell.

Through the above analysis result, the apparatus for analyzing a fuel cell may analyze/determine that the discharge of generated water formed by the electrochemical reaction is suppressed when a size of the pore inside an electrode of the fuel cell is smaller than a (preset/derived) reference size.

The apparatus for analyzing a fuel cell may predict/determine/analyze that a continuous suppression phenomenon increases a mass transfer resistance phenomenon of the hydrogen and air, which are fuel, eventually reducing fuel cell durability.

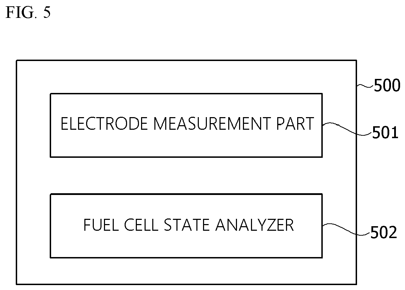

FIG. 5 is a block diagram illustrating an apparatus for analyzing a fuel cell according to an embodiment.

According to an embodiment, an apparatus 500 for analyzing a fuel cell includes an electrode measurement part 501 (for example, electrode measurer) configured to measure at least a portion of an electrode of the fuel cell, and a fuel cell state analyzer 502 configured to analyze a state of the fuel cell according to the measured result.

According to an embodiment, the electrode measurement part 501 may measure a pore size of an electrode of the fuel cell.

According to an embodiment, the electrode measurement part 501 may measure at least a portion of an air electrode of the fuel cell.

According to an embodiment, at least a portion of an electrode of the fuel cell may be formed by at least some of a coating process, a bonding process, and an attaching process.

According to an embodiment, the electrode measurement part 501 may calculate the pore size on the basis of a result of nitrogen supply to an electrode of the fuel cell.

According to an embodiment, a fuel cell state analyzer may analyze a state of the fuel cell on the basis of the measured pore size.

According to an embodiment, the apparatus 500 for analyzing a fuel cell may further include an impurity removal part (for example, impurity remover) (not shown) configured to remove moisture or impurities inside or around an electrode of the fuel cell.

The apparatus 500 for analyzing a fuel cell may provide an analysis method of pre-verifying degradation of the fuel cell through analysis of the pore size of an electrode.

The apparatus 500 for analyzing a fuel cell may measure the pore size of an electrode using a nitrogen adsorption and desorption method as an analysis method and has an effect of pre-verifying degradation of an MEA of the fuel cell without a long-term evaluation process.

In order to evaluate durability of the MEA of the fuel cell, an evaluation process should be performed after transfer/bonding/stacking. However, the apparatus 500 for analyzing a fuel cell may predict the degree of degradation by analyzing an electrode which is a pre-transfer product, thereby reducing costs used for transfer/bonding/stacking.

The apparatus 500 for analyzing a fuel cell may be a general-purpose apparatus for measuring a specific surface area of a solid material using a nitrogen adsorption and desorption method and provide a safe method which is convenient to use using only liquid nitrogen and nitrogen without using harmful materials.

The term "~ part" used in the embodiments refers to software or hardware components such as a field programmable gate array (FPGA) or an application specific integrated circuit (ASIC) and performs predetermined roles. However, the term "~ part" is not limited to software or hardware. The "~ part" may be formed to be stored in an addressable storage medium or to reproduce one or more processors. Thus, as an example, the "~ part" includes components such as software components, object-oriented software components, class components, and task components, and processes, functions, attributes, procedures, sub-routines, segments of program code, drivers, firmware, microcode, circuits, data, databases, data structures, tables, arrays, and variables. The functions provided in the components and the "~ part" may be combined into a smaller number of components and "~ parts" or may be further divided into additional components and "~ parts." In addition, the components and the "~ parts" may be implemented to reproduce one or more central processing units (CPUs) in a device or a secure multimedia card.

Various embodiments of the present disclosure do not list all available combinations but are for describing a representative aspect of the present disclosure, and descriptions of various embodiments may be applied independently or may be applied through a combination of two or more.

Moreover, various embodiments of the present disclosure may be implemented with hardware, firmware, software, or a combination thereof. In a case where various embodiments of the present disclosure are implemented with hardware, various embodiments of the present disclosure may be implemented with one or more application specific integrated circuits (ASICs), digital signal processors (DSPs), digital signal processing devices (DSPDs), programmable logic devices (PLDs), field programmable gate arrays (FPGAs), general processors, controllers, microcontrollers, or microprocessors.

The scope of the present disclosure may include software or machine-executable instructions (for example, an operation system (OS), applications, firmware, programs, etc.), which enable operations of a method according to various embodiments to be executed in a device or a computer, and a non-transitory computer-readable medium capable of being executed in a device or a computer each storing the software or the instructions.

A number of embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

## Claims

1. A method of fuel cell analysis, the method comprising:
measuring at least a portion of an electrode of a fuel cell to determine a measured result; and
analyzing a state of the fuel cell according to the measured result.

2. The method of claim 1, wherein measuring the at least the portion of the electrode of the fuel cell includes measuring a pore size of the electrode of the fuel cell.

3. The method of claim 1 or 2, wherein measuring the at least the portion of the electrode of the fuel cell includes measuring at least a portion of an air electrode of the fuel cell.

4. The method of any one of claims 1 to 3, further comprising:
forming at least a portion of the electrode of the fuel cell by at least some of a coating process, a bonding process, and an attaching process.

5. The method of any one of claims 2 to 4, wherein analyzing the state of the fuel cell includes analyzing the state of the fuel cell based on a measured pore size.

6. The method of any one of claims 1 to 5, wherein measuring the at least the portion of the electrode of the fuel cell further includes removing at least one of impurities and moisture located at least one of inside and around the electrode of the fuel cell.

7. The method of any one of claims 2 to 6, wherein measuring the pore size of the electrode of the fuel cell further includes calculating the pore size based on a result of nitrogen supply to the electrode of the fuel cell.

8. An apparatus for fuel cell analysis, the apparatus comprising:
an electrode measurer configured to measure at least a portion of an electrode of a fuel cell to determine a measured result; and
a fuel cell state analyzer configured to analyze a state of the fuel cell according to the measured result.

9. The apparatus of claim 8, wherein the electrode measurer is further configured to measure a pore size of the electrode of the fuel cell.

10. The apparatus of claim 8 or 9, wherein the electrode measurer is further configured to measure at least a portion of an air electrode of the fuel cell.

11. The apparatus of any one of claims 8 to 10, wherein the at least a portion of the electrode of the fuel cell is formed by at least some of a coating process, a bonding process, and an attaching process.

12. The apparatus of any one of claims 9 to 11, wherein the fuel cell state analyzer is further configured to analyze the state of the fuel cell based on the measured pore size.

13. The apparatus of any one of claims 8 to 12, further comprising an impurity remover configured to remove at least one of impurities and moisture located at least one of inside and around the electrode of the fuel cell.

14. The apparatus of any one of claims 9 to 13, wherein the electrode measurer is further configured to calculate the pore size based on a result of nitrogen supply to the electrode of the fuel cell.
